(19)

**Europäisches Patentamt**
**European Patent Office**
**Office européen des brevets**

(11) **EP 4 641 925 A1**

(12) **EUROPEAN PATENT APPLICATION**

(43) Date of publication:
**29.10.2025 Bulletin 2025/44**

(21) Application number: **24172817.9**

(22) Date of filing: **26.04.2024**

(51) International Patent Classification (IPC):
***H03D 7/14*** *(2006.01)*

(52) Cooperative Patent Classification (CPC):
**H03D 7/1441; H03D 7/1458;** H03D 2200/0019;
H03D 2200/009

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **NEOFYTOU, Marios**
**5656 AG Eindhoven (NL)**

• **GANZERLI, Marcello**
**5656 AA Eindhoven (NL)**
• **VAN DER HEIJDEN, Mark Pieter**
**5656 AE Eindhoven (NL)**
• **JANSEN, Feike Guus**
**5656 AE Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **GILBERT MIXER**

(57)     The disclosure relates to a Gilbert mixer for a radar transceiver. Example embodiments include a Gilbert mixer (1800) comprising: first and second multi-finger field effect transistor, FET, devices (1101, 1101'), each FET device (1101, 1101') comprising a plurality of gate fingers (G1-G12, G1'-G12') arranged along a longitudinal axis (L, L') between alternating source terminals (S1-S6) and drain terminals (D1-D7), wherein the plurality of gate fingers (G1-G4, G1'-G4') of each FET device (1101, 1101') extend transverse to the longitudinal axis (L, L') of the FET devices (1101, 1101'); first and second pairs of voltage rails (103a,b, 103a',b') arranged parallel to the longitudinal axis (L, L') across the first and second FET devices (1101, 1101') respectively, each of the first and second pairs of voltage rails (103a,b, 103a',b') comprising an upper rail (103a, 103a') and a lower rail (103b, 103b'); a first gate interconnect (111) connecting the upper rail (103a) of the first pair of voltage rails (103a,b) and the lower rail (103b') of the second pair of voltage rails (103a',b') to a first input terminal (vg0); and a second gate interconnect (112) connecting the lower rail (103b) of the first pair of voltage rails (103a,b) and the upper rail (103a') of the second pair of voltage rails (103a',b') to a second input terminal (vg180),wherein alternating adjacent pairs of gate fingers (G1-G12) of the first FET device (1101) are connected to respective upper and lower rails (103a, 103b) of the first pair of voltage rails (103a,b) and alternating adjacent pairs of gate fingers (G1'-G12') of the second FET device (1101') are connected to respective upper and lower rails (103a', 103b') of the second pair of voltage rails (103a',b').

Fig. 18

## Description

Field

The disclosure relates to a Gilbert mixer for a radar transceiver.

Background

Gilbert mixers are commonly used in automotive radar and communication transceivers to implement the functions of up-conversion and down-conversion. Typically, Gilbert mixers suffer from frequency dependent local oscillator (LO) leakage. This leakage is mainly caused by asymmetry in the circuit layout of the Gilbert mixer. In radar systems that utilise Doppler Division Multiplexing (DDM) encoding, this LO leakage results in the repetitive occurrence of the same phase error. This can result in spurious frequencies in the Doppler spectrum that may exceed the noise floor, degrading radar sensitivity. In communication systems, LO leakage also limits the error vector magnitude (EVM) and the resulting channel throughput.

When considering millimetre wave radar systems, the circuit layout of the Gilbert mixer is critical. Unequal trace lengths in the order of micrometres may map to phase errors of multiple degrees, introducing LO leakage which degrades the Gilbert mixer performance. A general problem therefore is how to reduce LO leakage in Gilbert mixers.

Summary

According to a first aspect there is provided a Gilbert mixer comprising:

first and second multi-finger field effect transistor, FET, devices, each FET device comprising a plurality of gate fingers arranged along a longitudinal axis between alternating source terminals and drain terminals, wherein the plurality of gate fingers of each FET device extend transverse to the longitudinal axis of the FET device;
first and second pairs of voltage rails arranged parallel to the longitudinal axis across the first and second FET devices respectively, each of the first and second pairs of voltage rails comprising an upper rail and a lower rail;
a first gate interconnect connecting the upper rail of the first pair of voltage rails and the lower rail of the second pair of voltage rails to a first input terminal; and
a second gate interconnect connecting the lower rail of the first pair of voltage rails and the upper rail of the second pair of voltage rails to a second input terminal,
wherein alternating adjacent pairs of gate fingers of the first FET device are connected to respective upper and lower rails of the first pair of voltage rails and alternating adjacent pairs of gate fingers of the second FET device are connected to respective upper and lower rails of the second pair of voltage rails.

The plurality of gate fingers of each FET device may be aligned orthogonal to the longitudinal axis.

The second FET device may be offset in a direction orthogonal to the longitudinal axis relative to the first FET device.

The Gilbert mixer may further comprise:

a first drain interconnect connecting the plurality of drains of the first FET device to a first output terminal; and
a second drain interconnect connecting the plurality of drains of the second FET device to a second output terminal.

Each of the plurality of source terminals of the first FET device may be connected to a respective one of the plurality of source terminals of the second FET device.

The Gilbert mixer may further comprise first and second current rails, wherein alternating adjacent source terminals of the first FET device are connected to the respective first and second current rails.

Each of the first and second gate interconnects may comprise:

upper and lower arms connected to respective upper and lower voltage rails of the pairs of voltage rails; and
a joining member connecting the upper arm to the lower arm and connecting a gate interconnect of the first and second gate interconnects to a respective input terminal of the first and second input terminals.

The first gate interconnect may be arranged to at least partially overlay on top of the second gate interconnect.

The first gate interconnect and second gate interconnect may be symmetrical about an axis orthogonal to the longitudinal axis.

The upper and lower arms of the first gate interconnect may be arranged to at least partially overlay on the joining member of the second gate interconnect, wherein the joining member of the first gate interconnect is arranged to at least partially overlay on the upper and lower arms of the second gate interconnect.

Each of the first and second gate interconnects further comprise a via, wherein the via connects the joining member of the first and second gate interconnects to a respective input terminal of the first and second input terminals.

The Gilbert mixer may further comprise:

a third FET device aligned along the longitudinal axis of the first FET device;
a fourth FET device aligned along the longitudinal axis of the second FET device; and
third and fourth pairs of voltage rails arranged parallel to the longitudinal axis across the third and fourth FET devices respectively, each of the third and fourth pairs of voltage rails comprising an upper rail and a lower rail,
wherein the first gate interconnect connects the lower rail of the third pair of voltage rails and the upper rail of the fourth pair of voltage rails to the second input terminal, and the second gate interconnect connects the upper rail of the third pair of voltage rails and the lower rail of the fourth pair of voltage rails to the first input terminal.

The Gilbert mixer may further comprise a local oscillator generator configured to provide a non-inverted input signal to the first input terminal and an inverted input signal to the second input terminal.

The Gilbert mixer may further comprise first and second current sources connected to respective first and second current rails.

According to a second aspect there is provided a radar transmitter comprising a Gilbert mixer according to the first aspect. The radar transmitter may be part of a radar transceiver.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic diagram of an example transmit line for a Doppler division multiplexing (DDM) radar system;

Figure 2 is an example Doppler spectrum for the transmit line of Figure 1;

Figures 3a and 3b are schematic circuit diagrams of a transistor level implementation of an in-phase/quadrature-phase (I/Q) modulator incorporating a double balanced Gilbert cell based mixer;

Figure 4 is an example plot of LO phase error as a function of desired phase for the Gilbert mixer of Figures 3a and 3b;

Figure 5 is an example plot of LO leakage as a function of input signal frequency for the Gilbert mixer of Figures 3a and 3b;

Figure 6 is a schematic plot of instantaneous frequency for a given transmitter against time for the transmit line of Figure 1;

Figure 7 is a further example Doppler spectrum for the transmit line of Figure 1;

Figure 8 is a further example Doppler spectrum for the transmit line of Figure 1;

Figure 9 is a schematic diagram of an example transmitter for a quadrature amplitude modulated (QAM) communication system;

Figure 10 is a schematic constellation diagram for the communication system of Figure 9;

Figure 11a is a schematic diagram of a multi-finger MOSFET device at a first stage of manufacture;

Figure 11b is a schematic circuit diagram of the device of Figure 11a;

Figure 12a is a schematic diagram of the MOSFET device of Figure 11a at a second stage of manufacture;

Figure 12b is a schematic circuit diagram of the device of Figure 12a;

Figure 13a is a schematic diagram of the MOSFET device of Figure 12a at a third stage of manufacture;

Figure 13b is a schematic circuit diagram corresponding to the MOSFET device of Figure 13a;

Figure 14a is a schematic diagram of pair of MOSFET devices with shared source connections;

Figure 14b is a schematic circuit diagram corresponding to the pair of devices of Figure 14a;

Figures 15a-c and 16a-c are schematic diagrams of first and second gate interconnects for a Gilbert mixer;

Figure 17 is a schematic diagram of an example arrangement of a combined first and second gate interconnect;

Figure 18 is a schematic diagram of an example double balanced Gilbert mixer with interconnects;

Figure 19 is a schematic diagram of an example double balanced Gilbert mixer with four multi-finger MOSFET devices in a symmetric arrangement;

Figure 20 is a schematic circuit diagram corresponding to a section of the Gilbert mixer of Figure 19; and

Figures 21 and 22 are example plots of LO phase error as a function of desired phase for example Gilbert mixers.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

Detailed description of embodiments

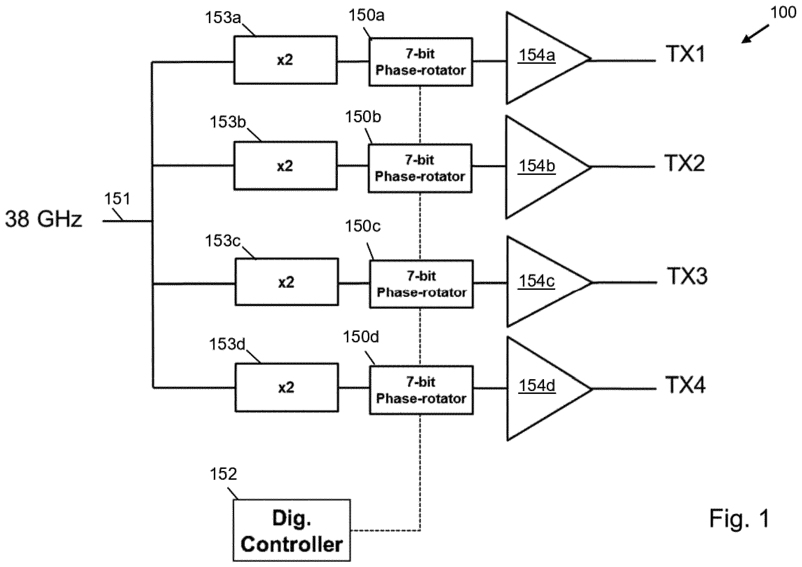

Figure 1 illustrates an example transmit line 100 for a Doppler division multiplexing (DDM) radar system. The transmit line 100 comprises a plurality of transmitter outputs TX1-TX4 corresponding to a plurality of phase rotators 150a-d. Each of the phase rotators 150a-d is configured to receive an input signal from a common input terminal 151 via a frequency doubler 153a-d and is connected to common digital controller 152. Each of the plurality of phase rotators 150a-d is configured to provide a phase rotated output signal to a respective amplifier 154a-d that provides the transmitter output TX1-TX4. The digital controller 152 is configured to provide a control signal to each of the phase rotators 150a-d to control a relative phase shift between the plurality of phase rotated output signals. Each of the plurality of transmitter outputs TX1-TX4 is phase rotated and offset in frequency relative to the input signal 151.

The signal received by a receiver of the radar system is the sum of the transmitted signals TX1-TX4 after reflection from one or more objects. The phase difference and frequency offset of the transmitted signals allows the plurality of transmitted signals to be recovered by the radar system.

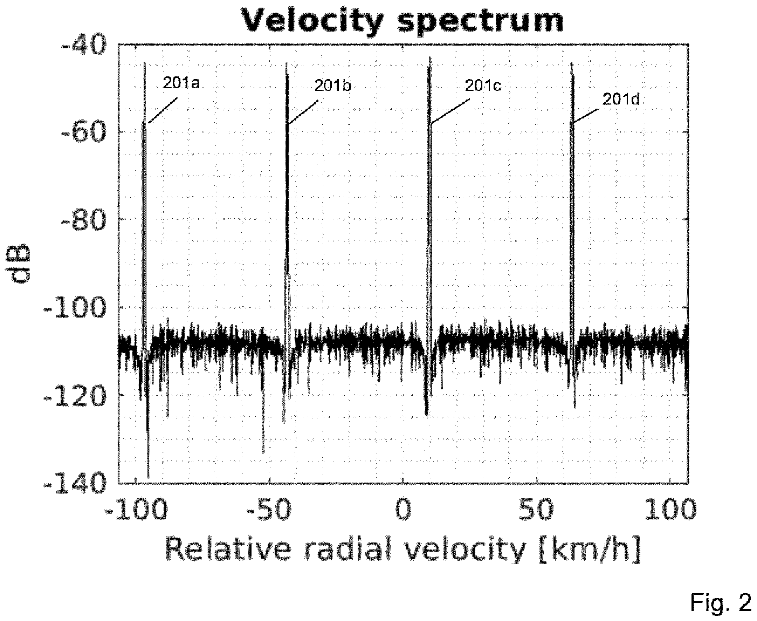

The input signal at input terminal 151 may be a sequence of frequency modulated continuous wave (FMCW) signals. The radar system may perform a 2D FFT operation to estimate distance from objects and relative radial velocity of objects (from the measured Doppler frequency). This is illustrated by the Doppler spectrum in Figure 2. The doppler spectrum is for a single reflector and the transmit line 100 of Figure 1. Frequency peaks 201a-d each correspond to Doppler frequency measurements arising from the respective transmitted signals TX1-TX4. In the example of Doppler spectrum, the frequency offset between the transmitted signals TX1-TX4 is equal.

The maximum Doppler frequency that can be unambiguously measured is inversely proportional to the duration of a single FMCW frequency ramp, including settling time and time of flight. To fulfil the sampling theorem, the frequency offset between the transmitted signals TX1-TX4 has to be smaller than the maximum Doppler frequency. This means that the phase rotation between the plurality of transmitted signals from the plurality of transmitters TX1-TX4 is crucial to allow the plurality of transmitted signals to be recovered from the sum of received signals received by the radar system.

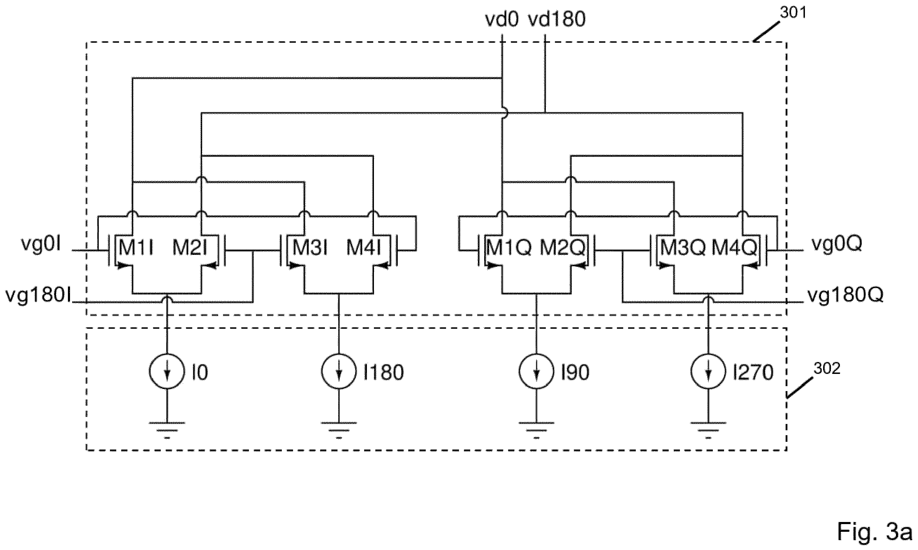

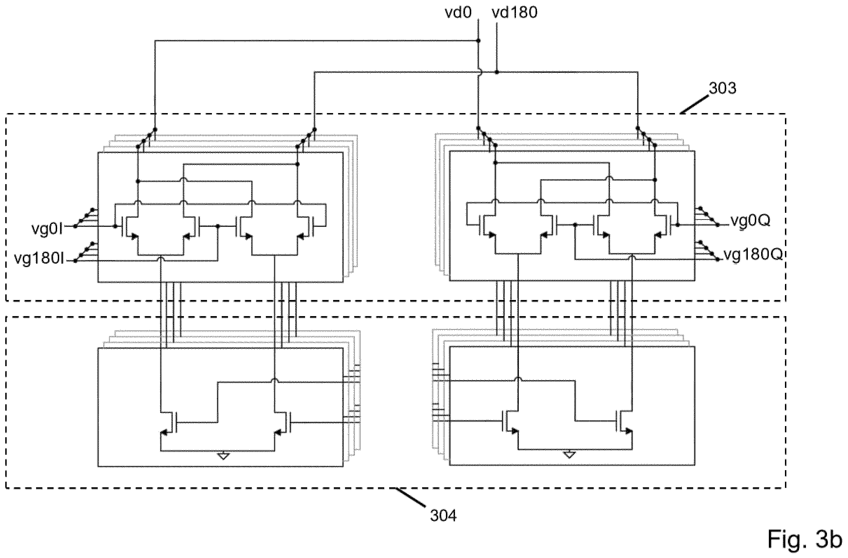

Potential circuit level implementations of the phase rotators 150a-d of the transmit line 100 are shown in Figure 3a and Figure 3b. Figure 3a and Figure 3b are based on a double balanced Gilbert cell mixer 301, 303 and implement a weighted sum of quadrature RF signals. Input signals vg0I, vg180I and vg0Q, vg180Q are the RF in-phase and quadrature-phase input frequency ramps, while output signals vd0 and vd180 are the phase-rotated output signals. The weighting function can be implemented solely by the baseband circuitry 302, as in Figure 3a, or by the contribution of both the baseband circuitry 304 and the Gilbert mixer 303 in Figure 3b. In the latter, the Gilbert mixer 303 is segmented in binary or thermometer (or a combination of both) with the source nodes not shorted together, different to the Gilbert mixer 301 shown in Figure 3a.

Asymmetries or imperfections in the physical layout of the Gilbert mixer can result in local oscillator (LO) leakage and subsequent phase error in the phase rotated output signals vd0, vd180. LO leakage may be caused by, among other things: i) asymmetries in coupling from input to output (e.g. vg to vd); ii) offset in baseband currents; and iii) unequal MMW (vg and vd) trace lengths of transistors M1, M3 and M2, M4.

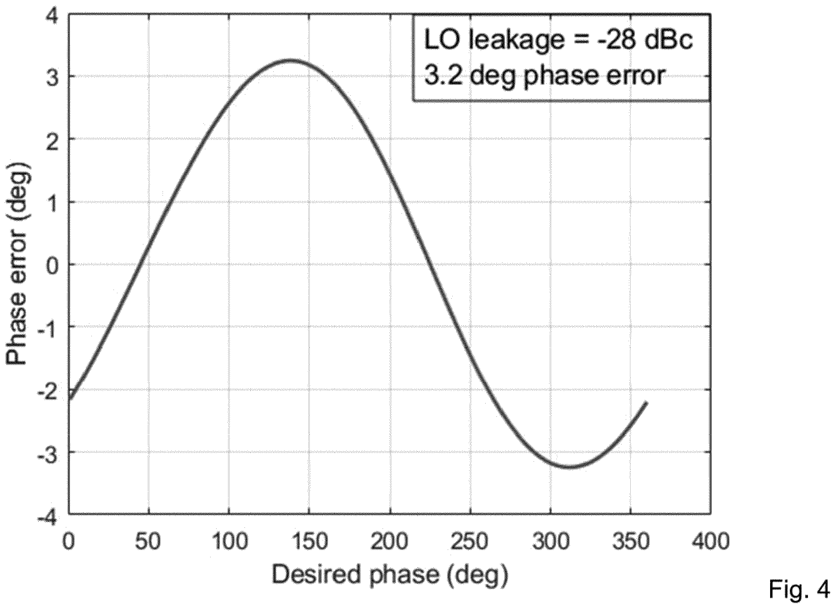

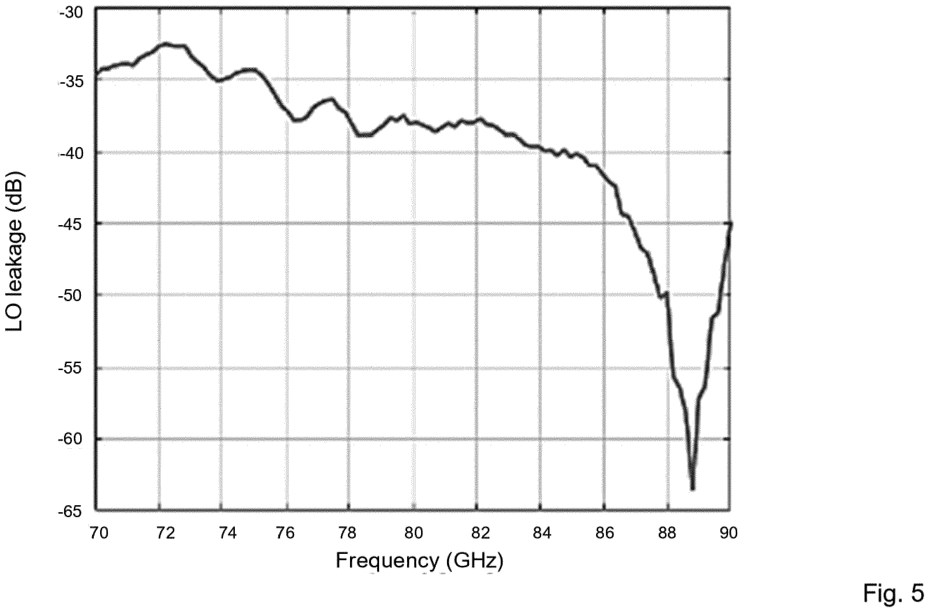

Figure 4 shows an example plot of phase error for a phase rotator experiencing LO leakage. Such phase error is frequency dependent, therefore its effect changes during a frequency chirp, which is further illustrated in Figure 5. In order to mitigate the frequency-dependent LO feed-through, dynamic compensation would be needed, introducing dynamic effects which would compromise the chirp linearity.

The phase error generated by LO leakage shown in Figure 4 creates a deterministic pattern that is correlated to the desired phase. Repetitive usage of the same phase therefore leads to a repetitive occurrence of the same phase error. This leads to spurious frequencies in the Doppler spectrum. Spurious frequencies in the Doppler spectrum can exceed the thermal noise floor and degrade the sensitivity of the radar in proximity to strong reflectors.

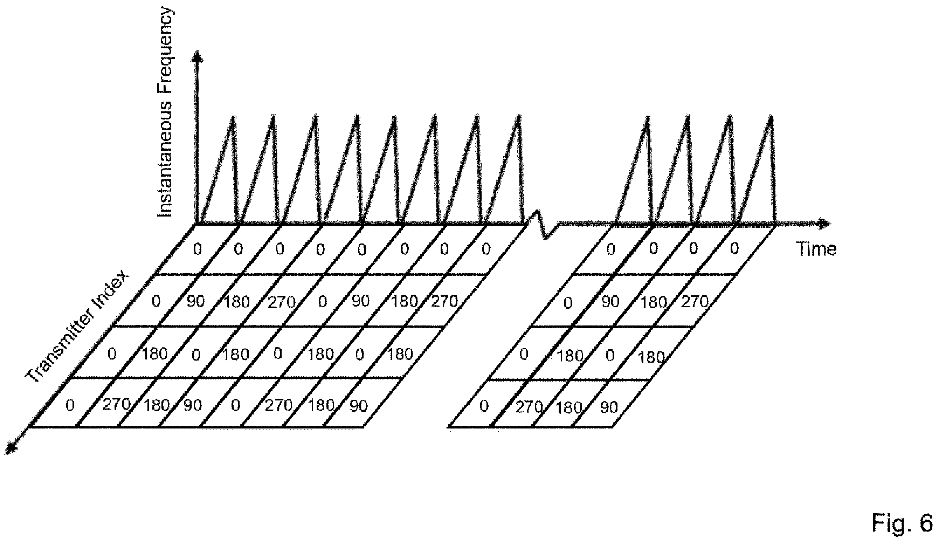

Figure 6 illustrates the transmit phases for a 4 transmitter DDM system, in which the repetitive nature of the different phases is indicated by the repetition of phase angles over time. This means that the same phase error is transmitted in a repetitive manner, leading to spurs in the Doppler dimension.

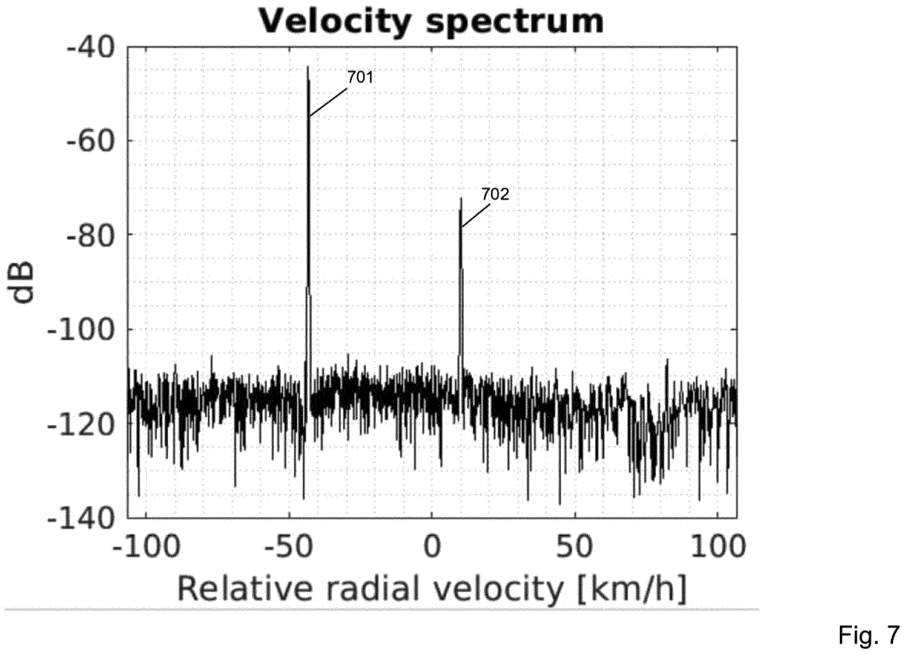

Figure 7 illustrates an example Doppler spectrum for transmit line 100 having the first transmission signal TX1 active and other transmission signals TX2-TX4 inactive. A first peak 701 corresponds to a Doppler frequency measurement relating to the transmitted signal from the transmitter TX1, while a second peak 702 is a spur originating from LO leakage.

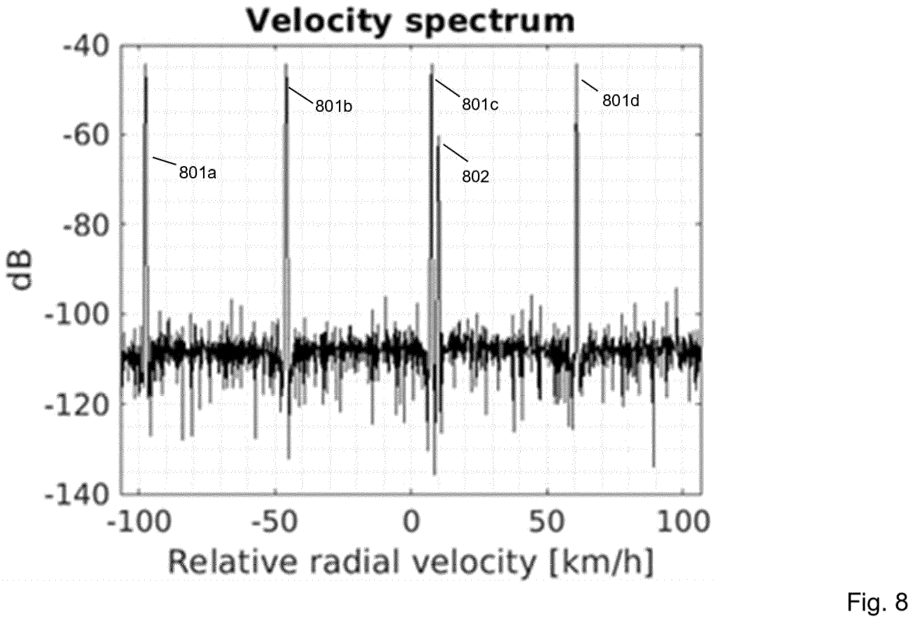

Figure 8 illustrates an alternative example Doppler spectrum where the transmitters are distributed over the Doppler spectrum in an irregular way. In this case, the spurious frequency 802 is visible even when all four transmitters are coded and active, resulting in four peaks 801a-d. The spurious frequency is a result of the superposition of the LO leakage from all transmitters. This spurious frequency is undesired because it can be mistaken as a true reflection, leading to ghost targets being detected. Increasing the detection threshold is not a practical solution because the dynamic range is compromised. In a practical automobile radar example, this may for example result in a small target (for example a child) beside a large target (such as a truck) going undetected due to the increased threshold.

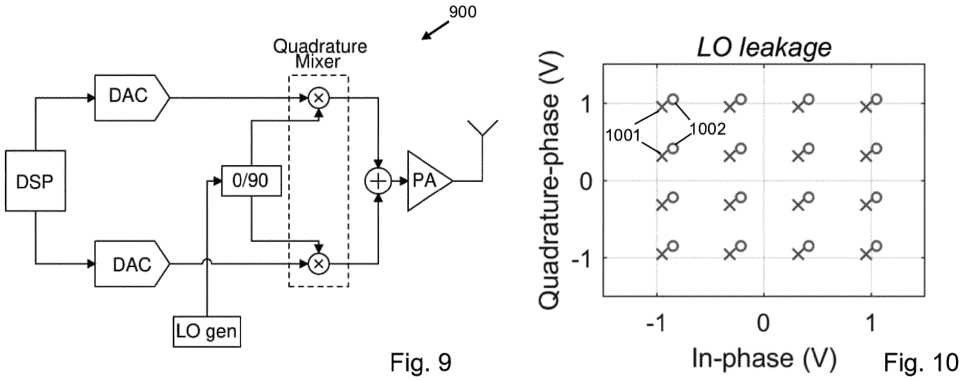

Figure 9 illustrates an example conventional direct conversion transmitter 900 for a quadrature amplitude modulated (QAM) communication system. Figure 10 illustrates a corresponding 16 QAM constellation diagram. Crosses 1001 on the constellation diagram 1000 represent the ideal location for the in-phase and quadrature components of the output signal. Circles 1002 on the constellation diagram represent the actual location for the in-phase and quadrature components of the output signal as a result of LO leakage.

The difference in position between the crosses 1001 and circles 1002 illustrate that LO leakage introduces a complex offset on the constellation diagram. This deteriorates the error vector magnitude (EVM) of the transmission system 900. EVM is a measure of the distance between ideal locations 1001 (crosses) and actual locations 1002 (circles). Assuming the EVM is caused solely by LO leakage and the constellation diagram is normalised to unit average power, the EVM is given by:

$$EVM = 10log_{10}(I_{DC}^2 + Q_{DC}^2)$$

Where $I_{DC} + jQ_{DC}$ is the complex offset between locations 1001, 1002 on the constellation diagram. EVM directly impacts data throughput of a communication system. For example, to convey 256QAM signals with a sufficiently low bit error rate, an EVM of at least -29 dB is required.

A solution is proposed herein that can lower ghost targets in FMCW automotive radar systems and improve EVM and throughput in communications systems by minimising LO leakage. This is achieved by using a symmetrical Gilbert mixer layout, as described in more detail below.

Typically, the devices M1-M4 in a Gilbert mixer of the type illustrated in Figure 3 are each multi-finger FET devices consisting of typically hundreds of fingers depending on the LO frequency. A high number of fingers will introduce significant physical distance between devices, which leads to unequal propagation lengths. This can result into LO leakage. As described herein, a solution to this proposes to merge the devices M1 with M3 and M2 with M4. This is done by providing multiple parallel double balanced Gilbert mixers having two fingers and with identical propagation lengths, which minimises LO leakage.

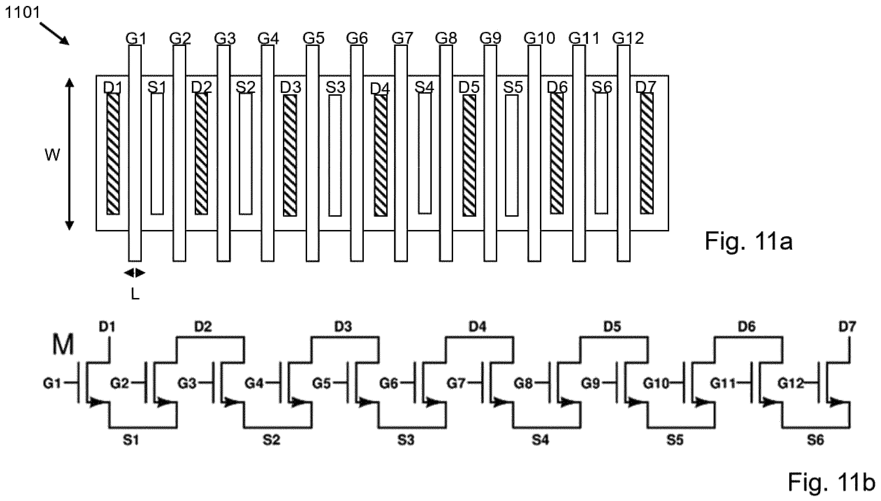

Figure 11a illustrates a MOSFET device 1101 with open gates G1-G12, drains D1-D7 and sources S1-S6 at a first stage of manufacture prior to forming connections to voltage rails and interconnects. Figure 11b is a schematic circuit diagram corresponding to the MOSFET device 1101. The plurality of gate fingers G1-G12 are arranged between alternating source terminals S1-S6 and drain terminals D1-D7, forming the series combination of transistors with adjacent common sources and adjacent common drains illustrated in Figure 11b. The width W and length L of the unit device is indicated in Figure 11a.

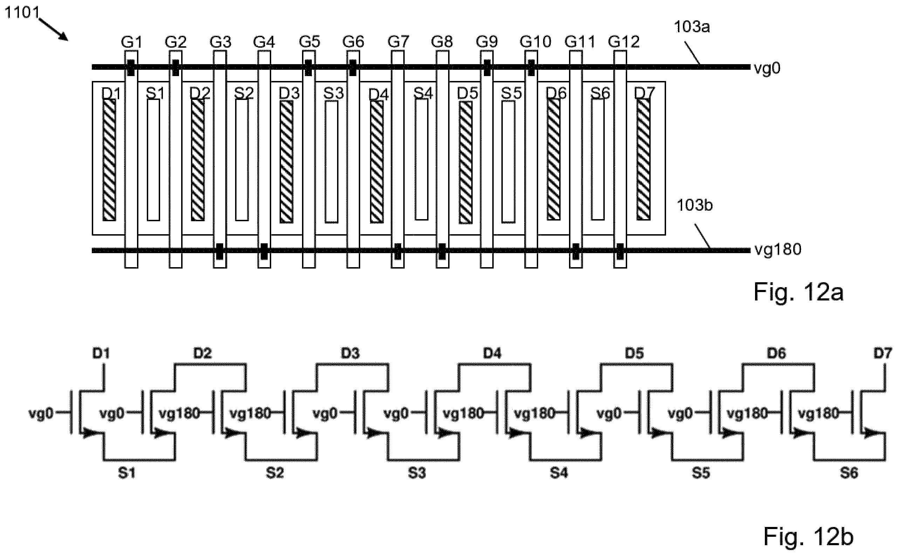

Figure 12a illustrates the MOSFET device 1101 at a second stage of manufacture with voltage rails 103a, 103b connected to groups of gates of the device 1101. Figure 12b is a corresponding schematic circuit diagram of the device 1101. The voltage rails 103a-b are arranged in parallel across the first device 1101. Alternating adjacent pairs of gate fingers G1&G2, G5&G6, G9&G10 are connected to an upper rail 103a of the voltage rails, while other alternating pairs of gate fingers G3&G4, G7&G8, G11&G12 are connected to a lower voltage rail 103b. The upper voltage rail 103a is connected to a first input vg0. The lower voltage rail 103b is connected to a second input vg180. This results in first and second gates G1, G2 being connected to the first input vg0 and third and fourth gates G3, G4 being connected to the second input vg180. Similarly, gates G5, G6 and G9, G10 are connected to the first voltage rail 103a while gates G7, G8 and G11, G12 are connected to the second voltage rail 103b. Vias are added at this stage on sources S1-S6 and drains D1-D7 for further interconnects.

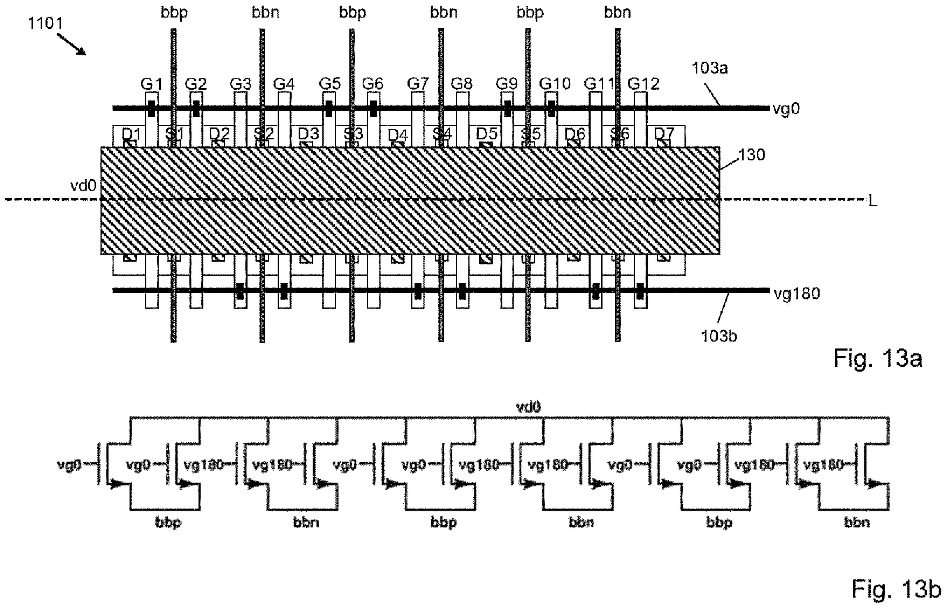

Figure 13a illustrates the MOSFET device 1101 at a third stage of manufacture. Figure 13b is a schematic circuit diagram corresponding to the device 1101 at this stage. The drains D1-D7 are all shorted together with a drain interconnect 130 extending along a longitudinal axis L of the device 1101 and which is connected to an output terminal vd0. The source terminals S1-S6 are extended outside the device edge for further interconnects. In this example, alternate source terminals are connected to respective alternate inputs bbp, bbn. In alternative examples, the sources S1-S6 may each be connected to a different input as in Figure 3b.

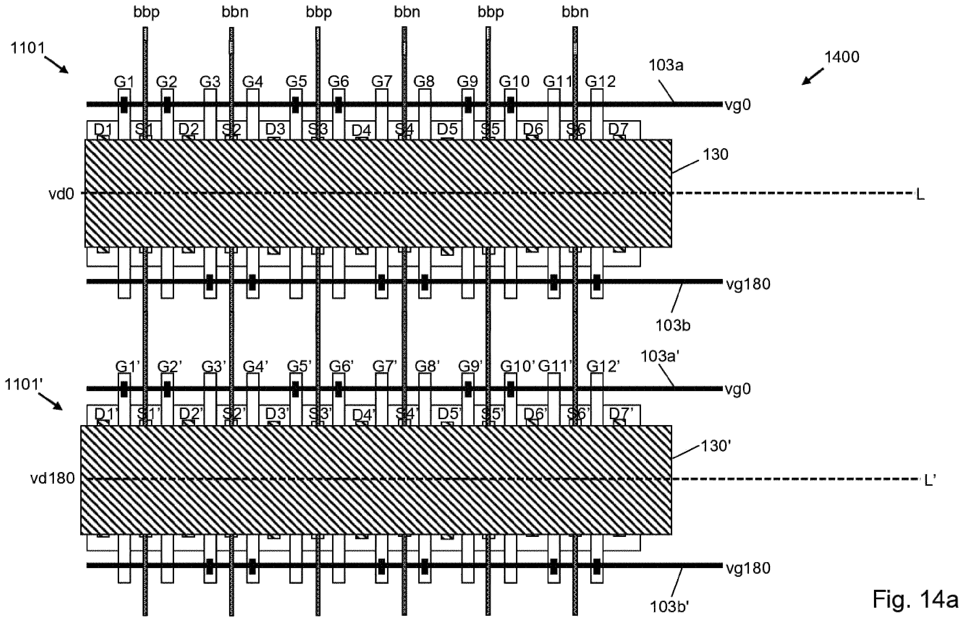

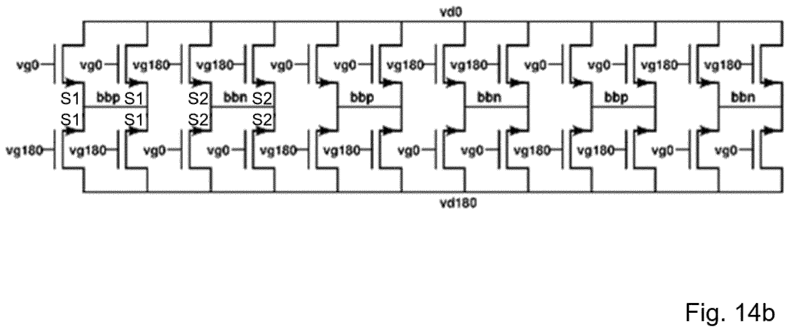

Figure 14a illustrates a Gilbert mixer 1400 having a pair of devices 1101, 1101' of the type shown in Figure 13a arranged in parallel, with each of the sources S1-S6, S1'-S6' connected together. Figure 14b is a schematic circuit diagram corresponding to this arrangement. The drain interconnect 130 of the first device 1101 is connected to a first output vd0 and the drain interconnect 130' of the second device 1101' is connected to a second output vd180.

The plurality of gate fingers G1-G12, source terminals S1-S6 and drain terminals D1-D7 of the first device 1101 are aligned transverse, in this case orthogonal, to the first longitudinal axis L. The corresponding plurality of gate fingers G1'-G12', source terminals S1'-S6' and drain terminals D1'-D7' of the second device 1101' are aligned transverse, in this case orthogonal, to the second longitudinal axis L'. The second device 1101' is offset in a direction orthogonal to the first longitudinal axis L relative to the first device 1101. Aligning the first and second devices 1101, 1101' as illustrated maintains the symmetry of the physical layout of the Gilbert mixer, thereby reducing LO leakage that may be caused by unequal trace lengths between components.

The plurality of source terminals S1-S6 of the first device 1101 and the plurality of source terminals S1'-S6' of the second device 1101' extend transverse to the longitudinal axes L, L' to connect each source terminal S1-S6 of the first device 1101 to a respective source terminal S1'-S6' of the second device 1101'. This is illustrated in the circuit of Figure 14b where sources S1, S1' are connected at node bbp and sources S2, S2' are connected together at node bbn. The connection between each of the plurality of source terminals S1-S6 of the first device 1101 and the plurality of source terminals S1'-S6' of the second device 1101' may be made by a trace running from a via situated on a source terminal S1-S6 of the first device 1101 to a via situated on a corresponding source terminal S1'-S6' of the second FET device 1101'.

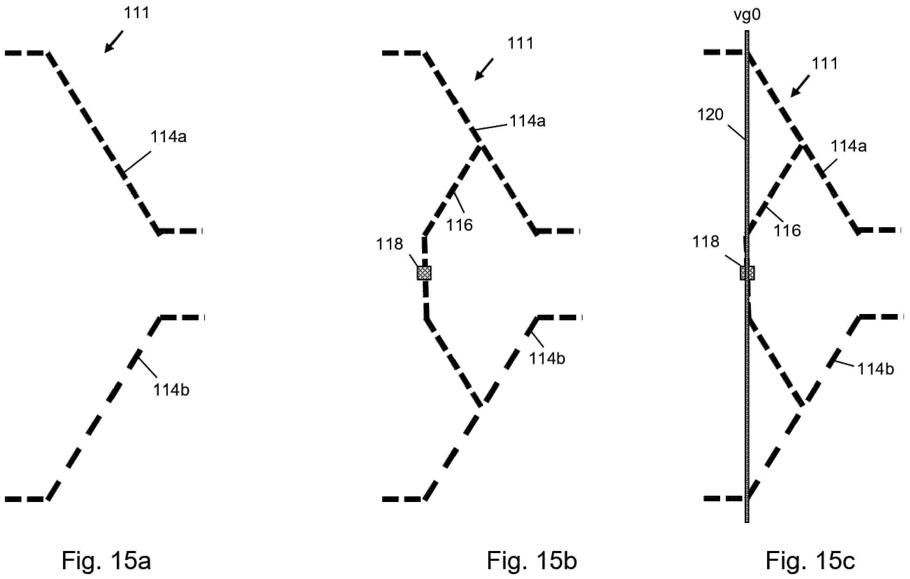

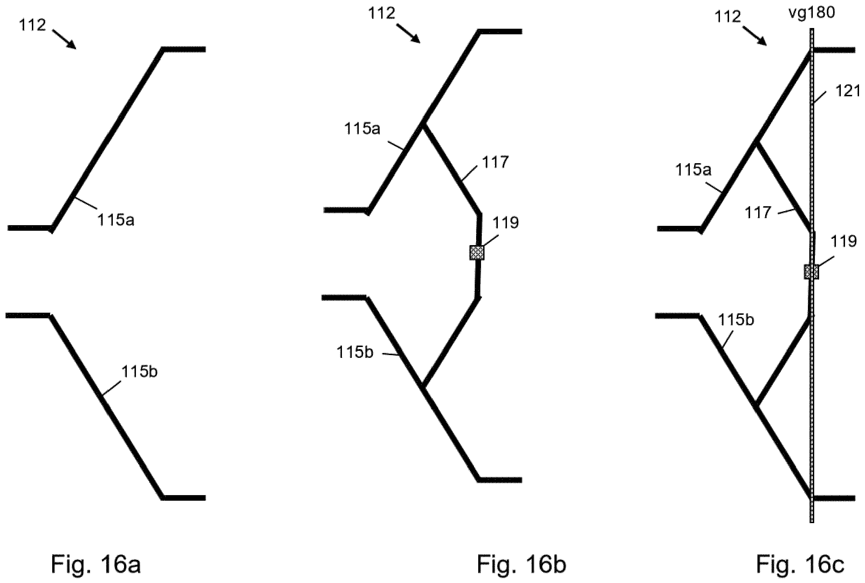

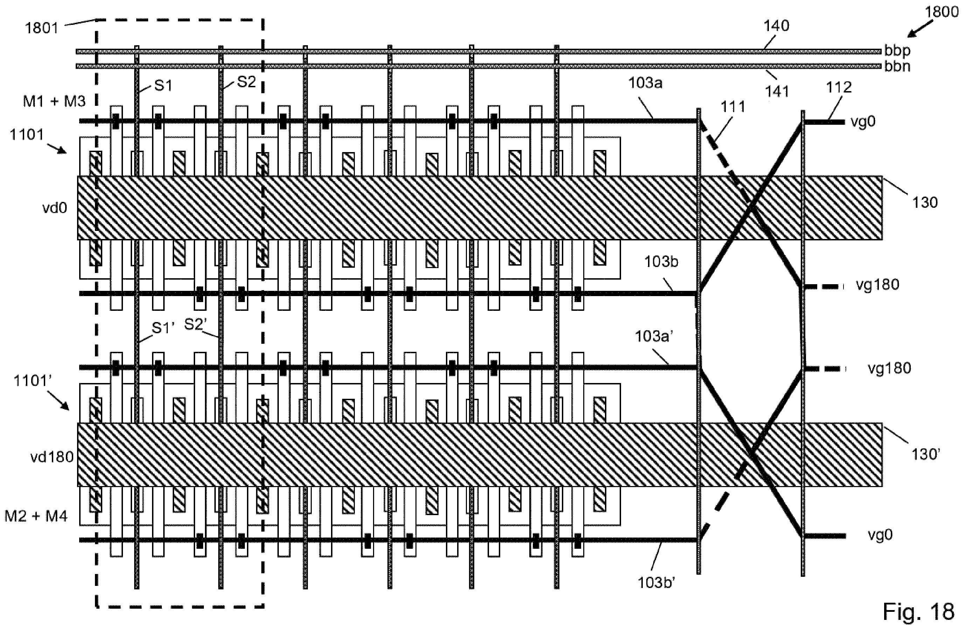

Figures 15a-c and 16a-c illustrate first and second example gate interconnects 111, 112 for a Gilbert mixer. In Figures 15a and 16a, each of the first and second gate interconnects 111, 112 comprise upper and lower arms 114a-b, 115a-b. Upper and lower arms 114a-b, 115a-b are connectable to respective upper and lower voltage rails of the pairs of voltage rails 103a-b, 104a-b, as illustrated in the Gilbert mixer of Figure 18. Figures 15b and 16b show a joining member 116, 117 connecting the upper arm 114a, 115a to the lower arm 114b, 115b and connecting a gate interconnect of the first and second gate interconnects 111, 112 to a respective input terminal of the first and second input terminals vg0, vg 180.

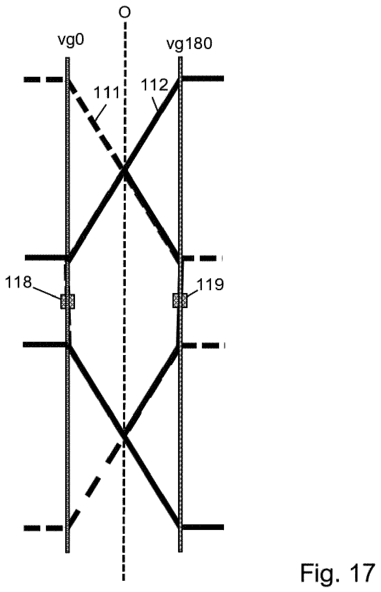

Figure 17 illustrates first and second gate interconnects 111, 112 in which the first gate interconnect 111 is arranged to at least partially overlay on top of the second gate interconnect 112. The first gate interconnect 111 and the second gate interconnect 112 are symmetrical about an axis O orthogonal to the longitudinal axis L, L' of the first and second FET devices 1101, 1101'. The upper and lower arms 114a-b of the first gate interconnect 111 are arranged to at least partially overlay on the joining member 117 of the second gate interconnect 112. The joining member 116 of the first gate interconnect 111 is arranged to at least partially overly on the upper and lower arms 115a-b of the second gate interconnect 112. Other arrangements of the first and second gate interconnects 111, 112 are also possible. Partially overlapping the first and second gate interconnects 111, 112 and introducing symmetry between the first and second gate interconnects 111, 112 as illustrated by assembly 113 reduces LO leakage caused by unequal trace lengths between components of the Gilbert mixer.

Each of the first and second gate interconnects 111, 112 comprises a via 118, 119. The via 118, 119 connects the joining member 116, 117 of the first and second gate interconnects 111, 112 to a respective input terminal of the first and second input terminals vg0, vg180. The first and second input terminals vg0, vg180 may be connected to the respective via 118, 119 by first and second input rails 121, 122. Alternatively, the first and second input terminals vg0, vg180 may be connected to the respective via 118, 119 by a PCB trace running from each of the vias 118, 119 and respective first and second input terminals vg0, vg180.

Figure 18 illustrates a double balanced Gilbert mixer 1800 incorporating the gate interconnects described above. The first gate interconnect 111 connects the upper rail 103a of the first pair of voltage rails 103a-b and the lower rail 103b' of the second pair of voltage rails 103a', 103b' to the first input terminal vg0. The second gate interconnect 112 connects the lower rail 103b of the first pair of voltage rails 103a-b and the upper rail 103a' of the second pair of voltage rails 103a', 103b' to the second input terminal vg180.

The Gilbert mixer 1800 further comprises first and second current rails 140, 141 arranged in parallel across the first FET device 1101. Alternating adjacent source terminals S1-S2 of the first FET device 1101 are connected to respective first and second current rails 140-141. A plurality of vias situated on the plurality of source terminals S1-S2 may connect first and second current rails 140, 141 to alternating adjacent source terminals S1-S2. First and second current sources bbp, bbn are connected to respective first and second current rails 140, 141. In alternative arrangements the sources may be connected differently, for example to a common rail. First and second current rails 140, 141 allow connection of plurality of source terminals S1-S2, S1'-S2' of both the first and second FET devices 1101, 1101' to current sources bbp, bbn whilst minimising PCB trace length difference. This minimises LO leakage due to offsets in input currents from first and second current sources bbp, bbn.

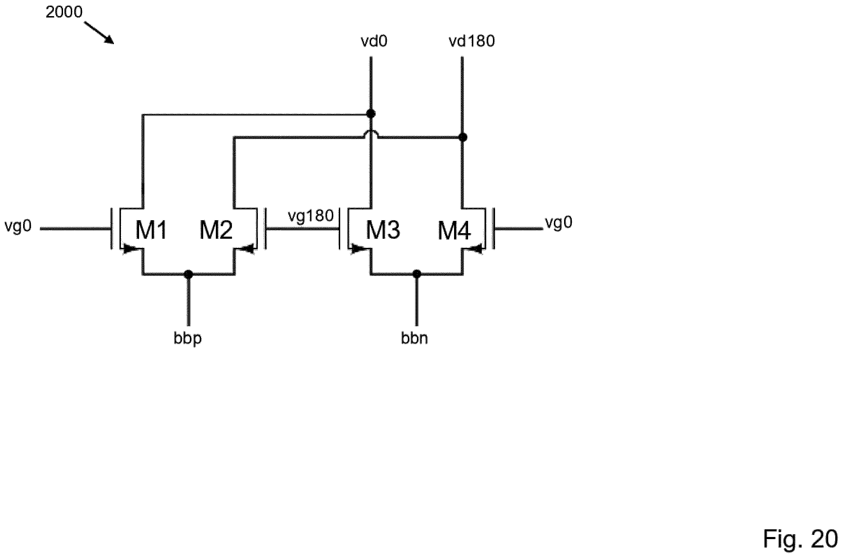

The unit 1801 indicated in the Gilbert mixer 1800 of Figure 18 represents a two finger double balanced Gilbert mixer corresponding to the circuit diagram in Figure 20, with transistors M1 and M3 in the first device 1101 and transistors M2 and M4 in the second device 1101'.

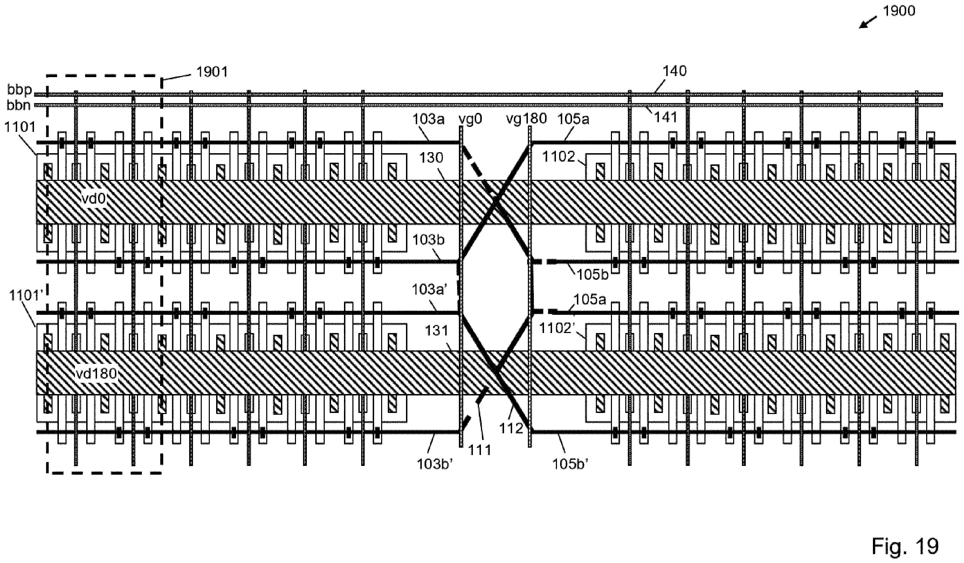

Figure 19 illustrates an alternative example Gilbert mixer 1900. Gilbert mixer 1900 comprises the first and second FET devices 1101, 1101'; the first and second pairs of voltage rails 103a-b, 103a'-b'; the first and second current rails 140, 141; the first and second gate interconnects 111, 112; and first and second drain interconnects 130, 131 of the Gilbert mixer 1800 of Figure 18.

Gilbert mixer 1900 comprises a third FET device 1102 aligned along the longitudinal axis L of the first FET device 1101 and a fourth FET device 1102' aligned along the longitudinal axis L' of the second FET device 1102'. The third FET device 1102 is offset along the longitudinal axis L of the first FET device 1101 relative to the first FET device 1101. The fourth FET device 1102' is offset along the longitudinal axis L' of the second FET device 1102' relative to the second FET device 1102'.

The Gilbert mixer 1900 further comprises third and fourth pairs of voltage rails 105a-b, 105a'-b' arranged in parallel across the third and fourth FET devices 1102, 1102' respectively. The first gate interconnect 111 connects the lower rail 105b of the third pair of voltage rails 105a-b and the upper rail 105a' of the fourth pair of voltage rails 105a'-b' to the first input terminal vg0. The second gate interconnect 112 connects the upper rail 105a of the third pair of voltage rails 105a-b and the lower rail 105b' of the fourth pair of voltage rails 105a'-b' to the second input terminal vg180.

The first drain interconnect 130 extends along the longitudinal axis L of the first and third devices 1101, 1102 to connect the plurality of drains of the third FET device 1102 to the first output terminal vd0. The second drain interconnect 131 extends along the longitudinal axis L' of the second and fourth devices 1101', 1102' to connect the plurality of drains of the fourth FET device 1102' to the second output terminal vd180. The first and second current rails 140, 141 extend across the third FET device 1102, wherein alternating adjacent source terminals of the third FET device 107 are connected to respective first and second current rails 140, 141.

The symmetry and overlapping assembly of the first and second gate interconnects 111, 112 maintains equal signal routing length for each of the plurality of voltage rail pairs 103a-b, 103a'-b', 105a-b, 105a'-b' to a respective input terminal of the first and second input terminals vg0, vg180, thus reducing LO leakage.

Figure 20 is a schematic circuit diagram of a Gilbert mixer 2000. Section 1801 of the Gilbert mixer 1900 of Figure 19 contains two merged Gilbert mixers each corresponding to Gilbert mixer circuit 2000. The first FET device 1101 contains transistors M1 and M3 of the mixer circuit 2000.

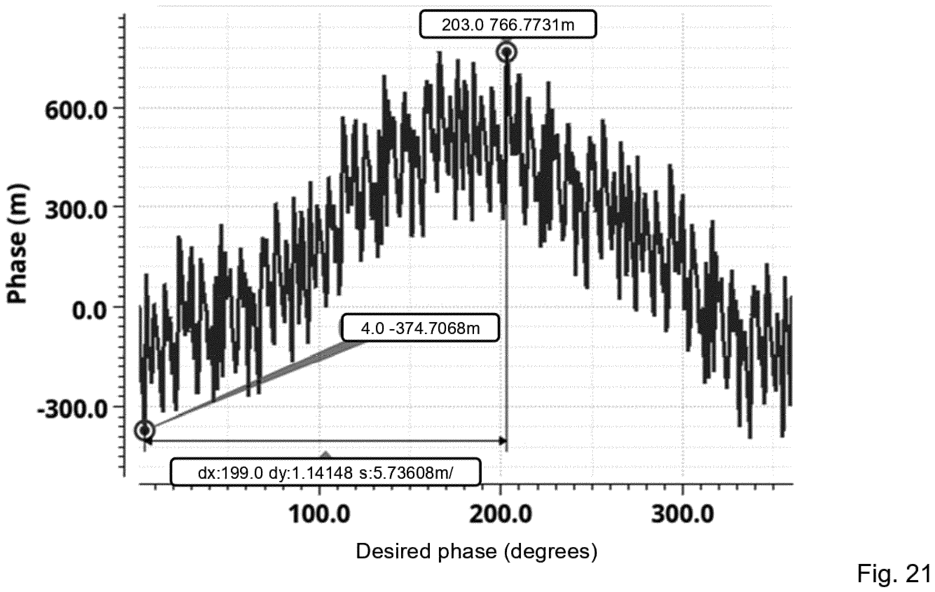

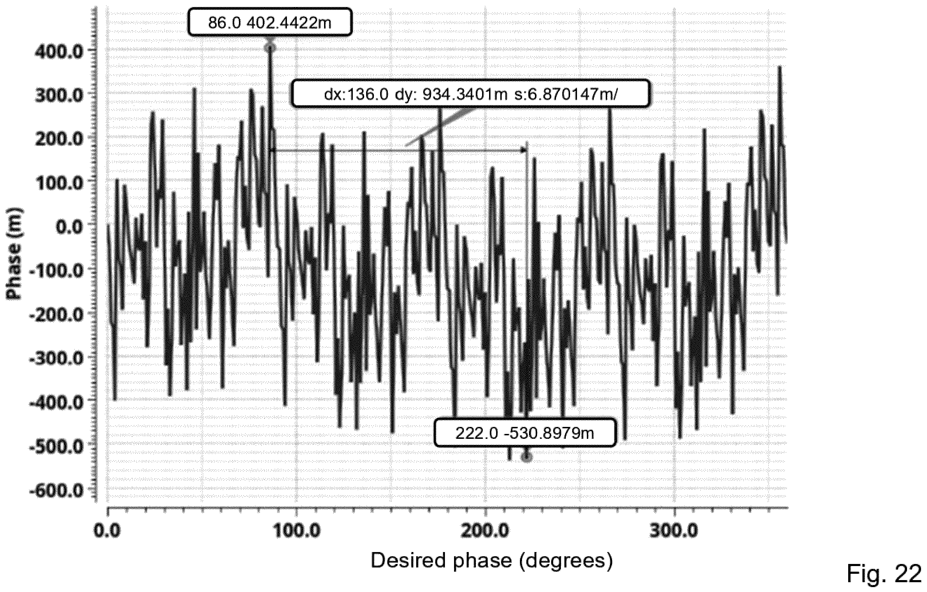

Figure 21 is a plot of phase error against desire phase for a conventional Gilbert mixer. The phase error can be seen to be largely dominated by LO leakage due to the sinusoidal shape of the curve. Figure 22 illustrates a corresponding plot of phase error for a Gilbert mixer with the merged layout as described above. The phase error is now lower and is not dominated by a periodic sinusoidal signal, indicating that merging the FET devices has the effect of reducing LO leakage due to improving the symmetry of the layout.

From reading the present disclosure, other variations and modifications will be apparent to the skilled person. Such variations and modifications may involve equivalent and other features which are already known in the art of Gilbert mixers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A Gilbert mixer (1800) comprising:

first and second multi-finger field effect transistor, FET, devices (1101, 1101'), each FET device (1101, 1101') comprising a plurality of gate fingers (G1-G12, G1'-G12') arranged along a longitudinal axis (L, L') between alternating source terminals (S1-S6) and drain terminals (D1-D7), wherein the plurality of gate fingers (G1-G4, G1'-G4') of each FET device (1101, 1101') extend transverse to the longitudinal axis (L, L') of the FET devices (1101, 1101');
first and second pairs of voltage rails (103a,b, 103a',b') arranged parallel to the longitudinal axis (L, L') across the first and second FET devices (1101, 1101') respectively, each of the first and second pairs of voltage rails (103a,b, 103a',b') comprising an upper rail (103a, 103a') and a lower rail (103b, 103b');
a first gate interconnect (111) connecting the upper rail (103a) of the first pair of voltage rails (103a,b) and the lower rail (103b') of the second pair of voltage rails (103a',b') to a first input terminal (vg0); and
a second gate interconnect (112) connecting the lower rail (103b) of the first pair of voltage rails

(103a,b) and the upper rail (103a') of the second pair of voltage rails (103a',b') to a second input terminal (vg180),

wherein alternating adjacent pairs of gate fingers (G1-G12) of the first FET device (1101) are connected to respective upper and lower rails (103a, 103b) of the first pair of voltage rails (103a,b) and alternating adjacent pairs of gate fingers (G1'-G12') of the second FET device (1101') are connected to respective upper and lower rails (103a', 103b') of the second pair of voltage rails (103a',b').

2. The Gilbert mixer (1800) of claim 1, wherein the plurality of gate fingers (G1-G12, G1'-G12') of each FET device (1100, 1100') are aligned orthogonal to the longitudinal axis (L, L').

3. The Gilbert mixer (1800) of claim 1 or claim 2 wherein the second FET device (1101') is offset in a direction orthogonal to the longitudinal axis (L, L') relative to the first FET device (1101).

4. The Gilbert mixer (1800) of any preceding claim, further comprising:

   a first drain interconnect (130) connecting the plurality of drains (D1-D7) of the first FET device (1101) to a first output terminal (vd0); and
   a second drain interconnect (130') connecting the plurality of drains (D1'-D7') of the second FET device (1101') to a second output terminal (vd180).

5. The Gilbert mixer (1800) of any preceding claim, wherein each of the plurality of source terminals (S1-S6) of the first FET device (1101) is connected to a respective one of the plurality of source terminals (S1'-S6') of the second FET device (1101').

6. The Gilbert mixer (1800) of any preceding claim, further comprising first and second current rails (140, 141), wherein alternating adjacent source terminals (S1-S6) of the first FET device (1101) are connected to the respective first and second current rails (140, 141).

7. The Gilbert mixer (1800) of any preceding claim, wherein each of the first and second gate interconnects (111, 112) comprise:

   upper and lower arms (114a-b, 115a-b) connected to respective upper and lower voltage rails of the pairs of voltage rails (103a,b, 103a',b'); and
   a joining member (116, 117) connecting the upper arm (114a, 115a) to the lower arm (114b, 115b) and connecting a gate interconnect of the first and second gate interconnects (111, 112) to a respective input terminal of the first and second input terminals (vg0, vg180).

8. The Gilbert mixer (1800) of claim 7, wherein the first gate interconnect (111) is arranged to at least partially overlay on top of the second gate interconnect (112).

9. The Gilbert mixer (1800) of claim 8, wherein the first gate interconnect (111) and second gate interconnect (112) are symmetrical about an axis (O) orthogonal to the longitudinal axis (L, L').

10. The Gilbert mixer (1800) of claim 9, wherein the upper and lower arms (114a-b) of the first gate interconnect (111) are arranged to at least partially overlay on the joining member (117) of the second gate interconnect (112), wherein the joining member (116) of the first gate interconnect (111) is arranged to at least partially overlay on the upper and lower arms (115a-b) of the second gate interconnect (112).

11. The Gilbert mixer (1800) of claim 10, wherein each of the first and second gate interconnects (111, 112) further comprise a via (118-119), wherein the via (118-119) connects the joining member (116, 117) of the first and second gate interconnects (111, 112) to a respective input terminal of the first and second input terminals (vg0, vg180).

12. The Gilbert mixer (1900) of any one of claims 7 to 11, further comprising:

   a third FET device (1102) aligned along the longitudinal axis (L) of the first FET device (1101);
   a fourth FET device (1102') aligned along the longitudinal axis (L') of the second FET device (1101'); and
   third and fourth pairs of voltage rails (105a,b, 105a',b') arranged parallel to the longitudinal axis (L, L') across the third and fourth FET devices (1102, 1102') respectively, each of the third and fourth pairs of voltage rails (105a,b, 105a',b') comprising an upper rail (105a, 105a') and a lower rail (105b, 105b'),
   wherein the first gate interconnect (111) connects the lower rail (105b) of the third pair of voltage rails (105a,b) and the upper rail (105a') of the fourth pair of voltage rails (105a',b') to the first input terminal (vg0), and the second gate interconnect (112) connects the upper rail (105a) of the third pair of voltage rails (105a,b) and the lower rail (105b') of the fourth pair of voltage rails (105a',b') to the second input terminal (vg180).

**13.** The Gilbert mixer (1800, 1900) of any preceding claim, further comprising a local oscillator generator configured to provide a non-inverted input signal to the first input terminal (vg0) and an inverted input signal to the second input terminal (vg180).

**14.** The Gilbert mixer (1800) of claim 6, further comprising first and second current sources (bbp, bbn) connected to respective first and second current rails (140, 141).

**15.** A radar transmitter (900) comprising a Gilbert mixer (1800, 1900) according to any preceding claim.

Fig. 1

Fig. 2

Fig. 3a

Fig. 3b

Fig. 4

EP 4 641 925 A1

Fig. 5

Fig. 6

Fig. 7

Fig. 8

Fig. 10

Fig. 9

EP 4 641 925 A1

1101

G1 G2 G3 G4 G5 G6 G7 G8 G9 G10 G11 G12

W

D1 S1 D2 S2 D3 S3 D4 S4 D5 S5 D6 S6 D7

L

Fig. 11a

M D1 D2 D3 D4 D5 D6 D7

G1 G2 G3 G4 G5 G6 G7 G8 G9 G10 G11 G12

S1 S2 S3 S4 S5 S6

Fig. 11b

Fig. 12a

Fig. 12b

Fig. 13a

Fig. 13b

EP 4 641 925 A1

Fig. 14a

Fig. 14b

Fig. 15a

Fig. 15b

Fig. 15c

EP 4 641 925 A1

Fig. 16c

Fig. 16b

Fig. 16a

Fig. 17

Fig. 18

Fig. 19

Fig. 20

Fig. 21

EP 4 641 925 A1

EP 4 641 925 A1

Fig. 22

Europäisches
Patentamt

European
Patent Office

Office européen
des brevets

# EUROPEAN SEARCH REPORT

**Application Number**

EP 24 17 2817

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LASKIN E ET AL: "Nanoscale CMOS Transceiver Design in the 90-170-GHz Range", IEEE TRANSACTIONS ON MICROWAVE THEORY AND TECHNIQUES, IEEE, USA, vol. 57, no. 12, 31 December 2009 (2009-12-31), pages 3477-3490, XP011284874, ISSN: 0018-9480, DOI: 10.1109/TMTT.2009.2034071 * figure 12 * | 1-15 | INV. H03D7/14 |
| A | US 9 385 657 B1 (DAFTARI NAVEEN [US] ET AL) 5 July 2016 (2016-07-05) * figure 5 * | 1-15 | |
| A | WO 2020/220326 A1 (HUAWEI TECH CO LTD [CN]) 5 November 2020 (2020-11-05) * figure 6 * | 1-15 | |

**TECHNICAL FIELDS SEARCHED (IPC)**

H03D

The present search report has been drawn up for all claims

| Place of search | Date of completion of the search | Examiner |
|---|---|---|
| Munich | 24 October 2024 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 2817

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2024

| Patent document cited in search report | | Publication date | Patent family member(s) | | Publication date |
|---|---|---|---|---|---|
| US 9385657 | B1 | 05-07-2016 | DK | 3278449 T3 | 31-05-2021 |
| | | | EP | 3278449 A1 | 07-02-2018 |
| | | | ES | 2879232 T3 | 22-11-2021 |
| | | | TW | 201637352 A | 16-10-2016 |
| | | | US | 9385657 B1 | 05-07-2016 |
| | | | WO | 2016160134 A1 | 06-10-2016 |
| WO 2020220326 | A1 | 05-11-2020 | CN | 113508523 A | 15-10-2021 |
| | | | EP | 3955457 A1 | 16-02-2022 |
| | | | US | 2022052645 A1 | 17-02-2022 |
| | | | WO | 2020220326 A1 | 05-11-2020 |

EPO FORM P0459

For more details about this annex : see Official Journal of the European Patent Office, No. 12/82